# EUROPEAN PATENT APPLICATION

(11) **EP 2 099 053 A1**
(43) Date of publication of application: **09.09.2009**
(21) Application number: 09154089.8
(22) Date of filing: 02.03.2009
(51) Int. Cl.: H01J 17/16, H01J 17/49, H01J 29/89, H01J 5/16, G02B 5/22

(54) **Display panel**

(30) Priority: 03.03.2008 KR 20080019619
(71) Applicant: Samsung SDI Co., Ltd., Suwon-si Gyeonggi-do (KR)
(72) Inventor: Lee, Sang-Mi, Gyeonggi-do (KR); Kwon, Do-Hyuk, Gyeonggi-do (KR); Baek, Seung-Goo, Gyeonggi-do (KR); Hwang, Cha-Won, Gyeonggi-do (KR)
(74) Representative: Gulde Hengelhaupt Ziebig & Schneider

(57) **Abstract**

A display panel is provided. The display panel includes: a panel assembly having a plurality of substrates for displaying an image by luminescence of a phosphor layer; and a filter assembly coupled to the panel assembly and having a minimum transmittance at a wavelength between 550 and 580 nanometers.

## Description

### BACKGROUND OF THE INVENTION

### 1. Field of the Invention

The present invention relates to a display panel, and more particularly, to a filter assembly of a display panel.

### 2. Description of the Related Art

Generally, flat display panels can be classified into light emitting flat display panels and light receiving flat display panels. Light emitting flat display panels include flat cathode ray tubes, plasma display panels, field emission display panels, and light emitting diode display panels. Light receiving flat display panels include liquid crystal display panels.

A plasma display panel is a flat panel display device that displays desired numbers, letters, or graphics using visible light emitted from phosphor layers excited by ultraviolet rays generated during a gas discharge that is initiated by applying a discharge voltage to a plurality of discharge electrodes formed on a plurality of substrates. A discharge gas is sealed between the plurality of substrates.

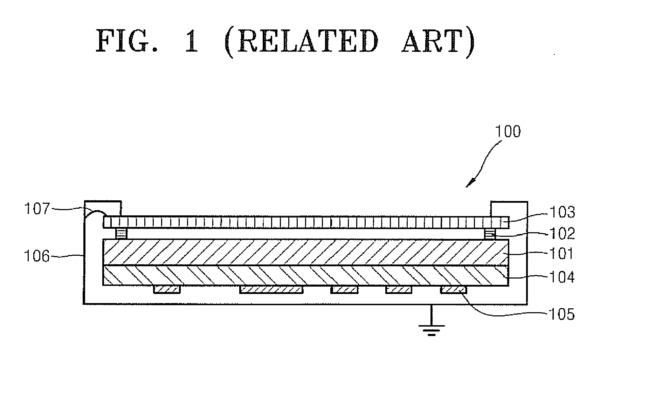

Referring to FIG. 1 that is a cross-sectional view of a conventional plasma display panel 100, the conventional plasma display panel 100 includes a panel assembly 101, a filter assembly 103 that is coupled to the front of the panel assembly 101 via a supporting member 102, a driving circuit unit 104 that is installed on the rear side of the panel assembly 101 and includes a circuit element 105, and a case 106 that contains the panel assembly 101, the filter assembly 103, and the driving circuit unit 104. The filter assembly 103 is coupled (e.g., grounded) to a chassis inside the case 106 via a conductive line 107.

The conventional plasma display panel 100 discharges electromagnetic wave, infrared ray, or neon luminescence at a wavelength of about 590 to 600 nanometers from the panel assembly 101 or the circuit element 105 of the driving circuit unit 104.

The filter assembly 103 blocks most emission in a neon luminescent region at a wavelength of about 590 to 600 nanometers. However, since a new phosphor layer having a new luminescent spectrum has been developed, a wavelength having a reduced color purity in a neon luminescent region and other regions is generated as well.

Nevertheless, a phosphor layer having a luminescent spectrum in an unnecessary region can enhance saturation of brightness, an afterimage, etc. in addition to a color purity, and thus it can be obliged to use the conventional plasma display panel in spite of some disadvantages.

### SUMMARY OF THE INVENTION

Embodiments of the present invention provide a display panel having an enhanced structure in which a filter assembly can improve color purity.

According to an embodiment of the present invention, there is provided a display panel including: a panel assembly having a plurality of substrates for displaying an image by utilizing luminescence of a phosphor layer in the panel assembly; and a filter assembly coupled to the panel assembly and having a minimum transmittance at a wavelength between 550 and 580 nanometers.

The filter assembly may include: a base film; an adhesive layer provided on, preferably directly on, i.e. with no additional layer in between, the base film; and an absorption coloring material included in the adhesive layer, wherein the absorption coloring material may include a compound having a maximum absorption rate at the wavelength between 550 and 580 nanometers.

A filter assembly may include: a base film; and an absorption coloring layer coated on, preferably directly on, i.e. with no additional layer in between, a side of the base film and including a compound having a maximum absorption rate at the wavelength between 550 and 580 nanometers.

The absorption coloring material may include a cyanine derivative dye and an acryl derivative binder.

The absorption coloring material may include a squarylium derivative dye and an acryl derivative binder.

The filter assembly may be adhered to a front surface of the panel assembly.

The filter assembly may include: a base glass; an adhesive layer on, preferably directly on, i.e. with no additional layer in between, a side of the base glass; and an absorption coloring material included in the adhesive layer, wherein the absorption coloring material may include a compound having a maximum absorption rate at the wavelength between 550 and 580 nanometers.

The filter assembly may include: a base glass; and an absorption coloring layer on, preferably directly on, i.e. with no additional layer in between, the base glass, wherein the absorption coloring layer may include a compound having a maximum absorption rate at the wavelength between 550 and 580 nanometers.

The filter assembly may be spaced apart from the panel assembly by a gap.

The minimum transmittance of the filter assembly may further include a first minimum transmittance at a wavelength between 490 and 500 nanometers and a second minimum transmittance at a wavelength between 590 and 600 nanometers.

The minimum transmittance of the filter assembly may include a transmittance between 0.01 and 40 % at the wavelength between 490 and 500 nanometers, preferably in the entire range between 490 and 500 nm, and at the wavelength between 590 and 600 nanometers, preferably in the entire range between 590 and 600 nm.

The filter assembly may have a visible light transmittance between 20 and 90 %. The phosphor layer may include a red phosphor layer formed of, preferably consists of Y(P,V)04;Eu, a green phosphor layer formed of, preferably consists of YAl3(BO3)Tb, and a blue phosphor layer formed of, preferably consists of BaMgAl10O17:Eu.

### BRIEF DESCRIPTION OF THE DRAWINGS

The above and other features and aspects of the present invention will become more apparent by describing in detail exemplary embodiments thereof with reference to the attached drawings in which:

FIG. 1 is a cross-sectional view of a conventional plasma display panel;

FIG. 2 is an exploded perspective view of a plasma display panel according to an embodiment of the present invention;

FIG. 3 is a partial cross-sectional view of the plasma display panel shown in FIG. 2 according to an embodiment of the present invention;

FIG. 4 is a partial cross-sectional view of a filter assembly according to an embodiment of the present invention;

FIG. 5 is a graph illustrating a spectrum of a phosphor layer according to an embodiment of the present invention;

FIG. 6 is a graph illustrating a spectrum of a filter assembly according to an embodiment of the present invention;

FIG. 7 is a graph illustrating a spectrum of a filter assembly according to another embodiment of the present invention;

FIG. 8 is a partial cross-sectional view of a filter assembly according to another embodiment of the present invention;

FIG. 9 is a partial cross-sectional view of a filter assembly according to another embodiment of the present invention;

FIG. 10 is a partial cross-sectional view of a filter assembly according to another embodiment of the present invention;

FIG. 11 is a partial cross-sectional view of a filter assembly according to another embodiment of the present invention;

FIG. 12 is a partial cross-sectional view of a filter assembly according to another embodiment of the present invention;

FIG. 13 is an enlarged partial cross-sectional view of a modification of the filter assembly shown in FIG. 4 according to an embodiment of the present invention;

FIG. 14 is an enlarged partial cross-sectional view of a modification of the filter assembly shown in FIG. 8 according to an embodiment of the present invention;

FIG. 15 is an enlarged partial cross-sectional view of a modification of the filter assembly shown in FIG. 8 according to another embodiment of the present invention;

FIG. 16 is an enlarged partial cross-sectional view of a modification of the filter assembly shown in FIG. 11 according to an embodiment of the present invention;

FIG. 17 is an enlarged partial cross-sectional view of a modification of the filter assembly shown in FIG. 11 according to another embodiment of the present invention; and

FIG. 18 is an enlarged partial cross-sectional view of a modification of the filter assembly shown in FIG. 11 according to another embodiment of the present invention.

FIG. 19 is a perspective view of a rear panel of a plasma display panel according to an embodiment of the present invention.

### DETAILED DESCRIPTION OF THE EXEMPLARY EMBODIMENTS

Hereinafter, exemplary embodiments of the present invention will be described more fully with reference to the accompanying drawings, in which the exemplary embodiments of the invention are shown.

Throughout the description, when it is referred to that a layer is provided, installed, coated formed "on" or adhered to another layer, it is preferably referred to that the layer is provided directly on the other layer, i.e. with no additional layer in between. When it is referred to that a layer is between to other layer, than the layer is preferably formed directly between the other layers, i.e. with no additional layer in between. In addition, when it is referred to a "minimum" or "maximum", a "local minimum" or "local maximum" is preferably referred to. Also, the layer may be provided indirectly on the other layer.

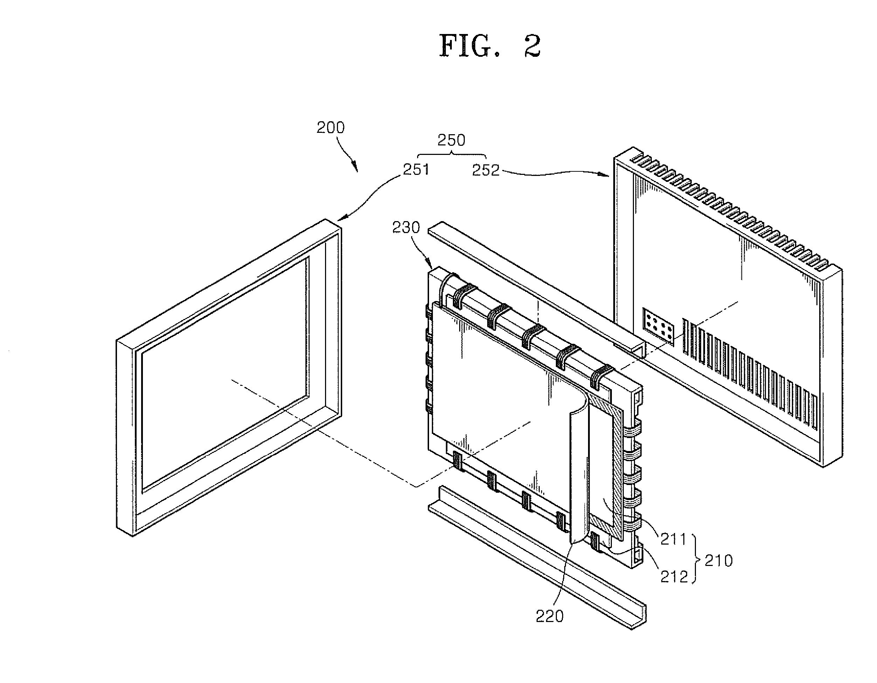

FIG. 2 is an exploded perspective view of a plasma display panel 200 according to an embodiment of the present invention.

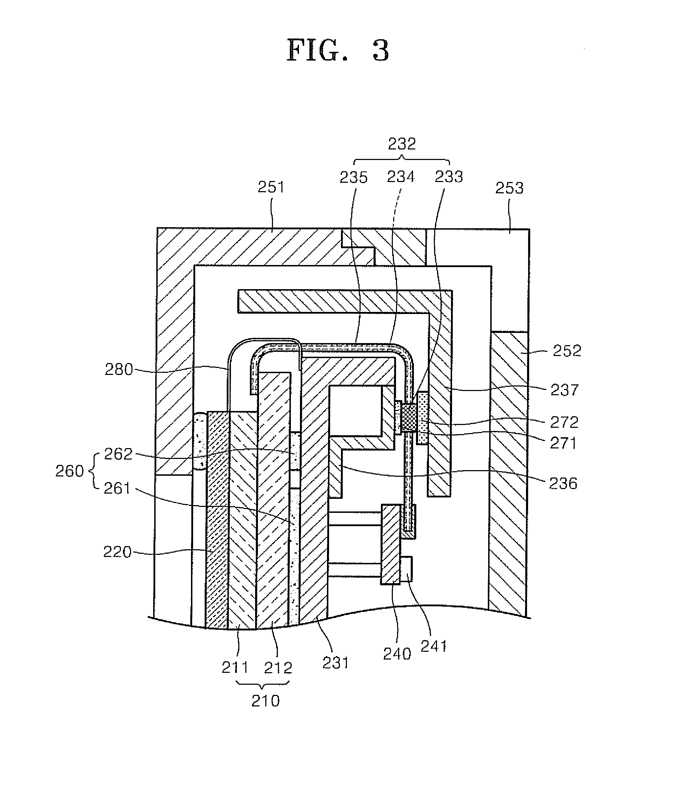

Referring to FIG. 2, the plasma display panel 200 includes a panel assembly 210, a filter assembly 220 adhered to the front of the panel assembly 210, a chassis base assembly 230 connected to the rear side of the panel assembly 210, a driving circuit unit 240 (shown in FIG. 3) installed on the rear side of the chassis base assembly 230, and a case 250 for storing the panel assembly 210, the filter assembly 220, the chassis base assembly 230, and the driving circuit unit 240.

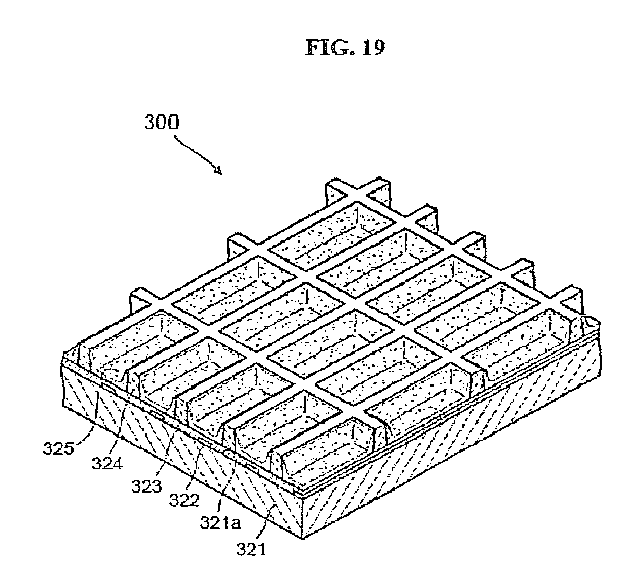

FIG. 19 is a perspective view of a rear panel of a plasma display panel according to an embodiment of the present invention. Referring to FIG. 19, The rear panel 320 includes a rear substrate 321, address electrodes 322 formed on a front surface 321 a of the rear substrate 321 crossing the sustain electrode pairs, a rear dielectric layer 323 covering the address electrodes 322, barrier ribs 324 formed on the rear dielectric layer 323 to partition discharge cells 326, and a phosphor layer 325 disposed in each discharge cell.

FIG. 3 is a partial cross-sectional view of the plasma display panel 200 shown in FIG. 2 according to an embodiment of the present invention.

Referring to FIG. 3, the panel assembly 210 includes a first substrate 211 and a second substrate 212 facing and connected to the first substrate 211. An inner space between the first substrate 211 and the second substrate 212 is sealed from the outside by coating a sealing member such as frit glass along inner edges of the front substrate 211 and the second substrate 212 that face each other.

If the panel assembly 210 is a surface discharge type panel, a discharge electrode is buried in a dielectric layer between the first substrate 211 and the second substrate 212. Discharge cells are defined by barrier ribs. Red, green, and blue phosphor layers are coated in the discharge cells. A discharge gas such as a Ne-Xe gas or a He-Xe gas is filled in the discharge cells.

The filter assembly 220 is adhered to the front side of the first substrate 211 through which visible light transmits. The filter assembly 220 is formed by stacking a plurality of functional films in order to block electromagnetic waves, ultraviolet rays, neon luminescent light or the reflection of external light that is generated from the panel assembly 210.

A chassis base 231 included in the chassis base assembly 230 is connected to the rear side of the second substrate 212 via an adhesion member 260. The adhesion member 260 is adhered to the rear center of the second substrate 212 and includes a thermal conductive sheet 261 that serves as thermal conductive medium for transferring heat generated from the panel assembly 210 while driven to the chassis base 231 and a double-sided tape 262 that fixes (or secure) the chassis base 231 to the panel assembly 210.

The driving circuit unit 240 is installed on the rear side of the chassis base 231 opposite to a side of the chassis base 231 where the panel assembly 210 is installed. A plurality of circuit elements 241 are embedded in the driving circuit unit 240. An end of a signal transferring unit 232 such as, but not limited to, a flexible printed cable is connected to the driving circuit unit 240 in which the plurality of circuit elements 241 are included. Another end of the signal transferring unit 232 is connected to terminals of each pair of discharge electrodes of the panel assembly 210 and inter-transfers electrical signals between the panel assembly 210 and the plurality of circuit elements 241.

The signal transferring unit 232 includes a driving integrated circuit (IC) 233, a plurality of leads 234 electrically connected to the driving IC 233, and a flexible film 235 for enclosing the plurality of leads 234.

A chassis reinforcing member 236 is adhered to the top and bottom ends and the rear side of the chassis base 231 in order to reinforce the rigidity of the chassis base 231. A cover plate 237 is installed on the rear end of the chassis base 231 in order to prevent the signal transferring unit 232 from damage.

The signal transferring unit 232 is disposed between the rear end of the chassis base 231 and the cover plate 237. Thermal grease 271 is disposed between the driving IC 233 and the chassis reinforcing member 236. A silicon sheet 272 is disposed between the driving IC 233 and the cover plate 237.

The case 250 (shown in FIG. 1) includes a front cabinet 251 installed in the front of the filter assembly 220 and a back cover 252 installed in the rear of the driving circuit unit 240. A plurality of through-holes 253 are formed in the top and bottom ends of the back cover 252.

The filter assembly 220 includes a film having a minimum transmittance at a wavelength between 550 and 580 nanometers.

The filter assembly 220 will be described in more detail below.

Like reference numerals in the previous figures denote like elements in the figures described below.

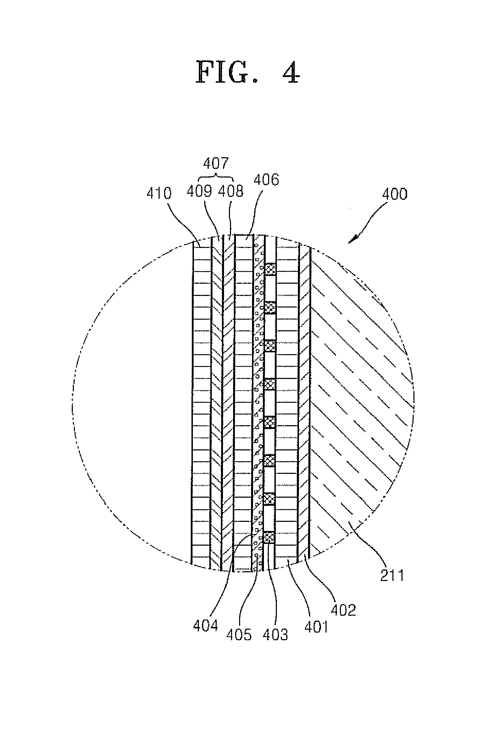

FIG. 4 is a partial cross-sectional view of a filter assembly 400 according to an embodiment of the present invention. Referring to FIG. 4, the filter assembly 400 includes a first base film 401. The first base film 401 is formed of, preferably consists of, for example, a high polymer resin selected from the group consisting of Polyethersulfone (PES), Polyacrylate (PAC), Polyetherimide (PEI), Polyethylene Naphthalate (PEN), Polyethylene Terephthalate (PET), Polyphenylene Sulfide (PPS), Polyimide (PI), Polycarbonate (PC), Cellulous Triacetate (CT), Cellulose Acetate Propionate (CAP), and combinations thereof.

A first adhesive layer 402 is disposed between a surface of the first base film 401 and the first substrate 211. The first adhesive layer 402 can be formed of, preferably consists of, but is not necessarily restricted thereto, a polymer adhesive such as a PSA adhesive layer and a rubber adhesive material. The filter assembly 400 is adhered to, preferably directly adhered to the front side of the first substrate 211 via the first adhesive layer 402.

An electromagnetic wave shield filter 403 is adhered to, preferably directly adhered to another surface of the first base film 401. The electromagnetic wave shield filter 403 is used to shield electromagnetic wave generated when the plasma display panel 200 is operating. The electromagnetic wave shield filter 403 is patterned in the form of a fine metal mesh. The electromagnetic wave shield filter 403 may be formed of, preferably consists of an electrical conductive material such as copper, silver, aluminum, platinum, steel, and an alloy thereof. Alternatively, the electromagnetic wave shield filter 403 may be formed of, preferably consists of a conductive ceramic material or a conductive carbon nanotube.

The electromagnetic wave shield filter 403 can be manufactured using various methods in order to pattern it in a metal mesh shape. For example, a plating or etching method is simpler in view of manufacturing processing and is suitable to patterning.

The electromagnetic wave shield filter 403 can be stacked by oxidizing a transparent conductive film such as an ITO film and a conductive metal layer such as copper formed thereon according to various embodiments of the present invention.

A ground line 280 shown in FIG. 3 is connected to the electromagnetic wave shield filter 403 through an area and is connected (or grounded) to the chassis base 231 or a conductive member of a front cabinet 251 shown in FIG. 3.

A second adhesive layer 404 is formed on, preferably directly on the electromagnetic wave shield filter 403 in order to cover the electromagnetic wave shield filter 403. The second adhesive layer 404 may be formed of, preferably consists of a polymer adhesive such as a PSA adhesive layer and a rubber adhesive material, like the first adhesive layer 402.

An absorption coloring material 405 is mixed in the second adhesive layer 404. The absorption coloring material 405 may include a compound having a maximum absorption ratio at a wavelength between 550 and 580 nanometers.

The reason for forming the absorption coloring material 405 is as follows.

The panel assembly 210 includes a phosphor layer that emits visible light by absorbing ultraviolet rays generated by a discharge gas such as an Xe gas filled in the discharge cells that is excited by a discharge voltage applied to discharge electrodes when the panel 200 is discharged.

For example, the phosphor layer may be a photo luminescence phosphor (PL) layer that emits light by a photo luminescence mechanism. For example, the phosphor layer is formed of, preferably consists of a material having luminescence efficiency at 147 nanometers so that it can be excited by vacuum ultraviolet rays generated from the Xe gas at 147 nanometers.

The phosphor layer may include one of a red phosphor layer, a green phosphor layer, or a blue phosphor layer in each discharge cell so that the panel 200 forms a color image. As such, each phosphor layer forms a sub-pixel.

The red phosphor layer may be formed of, preferably consists of Y(P,V)O₄;Eu, the green phosphor layer may be formed of, preferably consists of YAl₃(BO₃)Tb, and the blue phosphor layer may be formed of, preferably consists of BaMgAl₁₀O₁₇:Eu. Alternatively, the blue phosphor layer may be formed of, preferably consists of CaMgSi₂O₆:Eu or a compound of BaMgAl₁₀O₁₇:Eu and CaMgSi₂O₆:Eu, but the present invention is not limited thereto.

After the excited discharge gas in discharge spaces of the panel 200 is discharged, some electrons generated according to an ionization reaction do not collide to release energy and remain in the discharge spaces, therefore, the phosphor layer may include an additional phosphor layer that changes kinetic energy of the electrons to visible light in the discharge spaces in order to avoid loss of energy of the electrons, thereby preventing the energy from transforming to heat and preventing temperature increase.

The additional phosphor layer may be a cathode luminescence phosphor (CL) layer or a quantum dot phosphor (QD) layer. The CL layer may be formed of, preferably consists of sulfide phosphor. The QD layer emits light when atoms are stabilized at an atom energy level by receiving external energy since atoms do not interfere with each other. Thus, discharge gas can be excited at a low voltage, thereby increasing efficiency and enabling printing processing that is suitable to a large-sized panel.

In the phosphor layer that includes the red phosphor layer formed of, preferably consists of Y(P,V)O₄;Eu, the green phosphor layer formed of, preferably consists of YAl₃(BO₃)Tb, and the blue phosphor layer formed of, preferably consists of BaMgAl₁₀O₁₇:Eu, green color purity is reduced in a green region corresponding to, for example, a wavelength between 550 and 580 nanometers, in some embodiments of the present invention, between 550 and 560 nanometers, and color re-expression is lowered.

To avoid or reduce such problem, the second adhesive layer 404 includes the absorption color material 405. The absorption color material 405 includes a compound having a maximum absorption ratio at a wavelength, for example, between 550 and 580 nanometers.

The absorption coloring material 405 may be formed of, preferably consists of a compound of a cyanine derivative dye and an acryl derivative binder or a compound of a squarylium derivative dye and the acryl derivative binder.

The filter assembly 400 including the absorption coloring material 405 has a minimum transmittance at a wavelength between 550 and 580 nanometers that includes a luminescent spectrum of a green region.

The absorption coloring material 405 has a maximum absorption rate at each wavelength of a blue region corresponding to a wavelength between 490 and 500 nanometers and a neon region corresponding to a wavelength between 590 and 600 nanometers in order to absorb each wavelength in the luminescent spectrum.

One surface of a second base film 406 is adhered to, preferably directly to the surface of the second adhesive layer 404 in which the absorption coloring material 405 is mixed. The second base film 406, like the first base film 401, is formed of, preferably consists of, for example, a high polymer resin selected from the group consisting of Polyethersulfone (PES), Polyacrylate (PAC), Polyetherimide (PEI), Polyethylene Naphthalate (PEN), Polyethylene Terephthalate (PET), Polyphenylene Sulfide (PPS), Polyimide (PI), Polycarbonate (PC), Cellulous Triacetate (CT), Cellulose Acetate Propionate (CAP), and combinations thereof.

A reflection preventive layer 407 is formed on, preferably directly on another surface of the second base film 406.

The reflection preventive layer 407 includes an anti-reflection (AR) film layer 408 and an anti-glare (AG) film layer 409 in order to prevent a drop of visibility due to the reflection of an external light. However, the reflection preventive layer 407 may include one of the AR film layer 408 and the AG film layer 409 or may further include a hard coating layer, but the present invention is not limited thereto.

The thickness of the reflection preventive layer 407 may be between 2 and 7 micrometers. The hardness of a lead pencil is between 2 and 3 H. A haze value may be between 1 and 7 %. When the reflection preventive layer 407 includes the AR film layer 408, a difference of a light phase between a low refraction layer and a high refraction layer results in an offset of light and a reduction thereof. When the reflection preventive layer 407 includes the AG film layer 409, a protrusion having a diameter between 1 nanometer and 1 millimeters, in some embodiments, between 0.5 and 20 micrometers is formed on the surface of the AG film layer 409 to scatter light.

A third base film 410 is formed on, preferably directly on the surface of the reflection preventive layer 407 in order to prevent damage of the filter assembly 400.

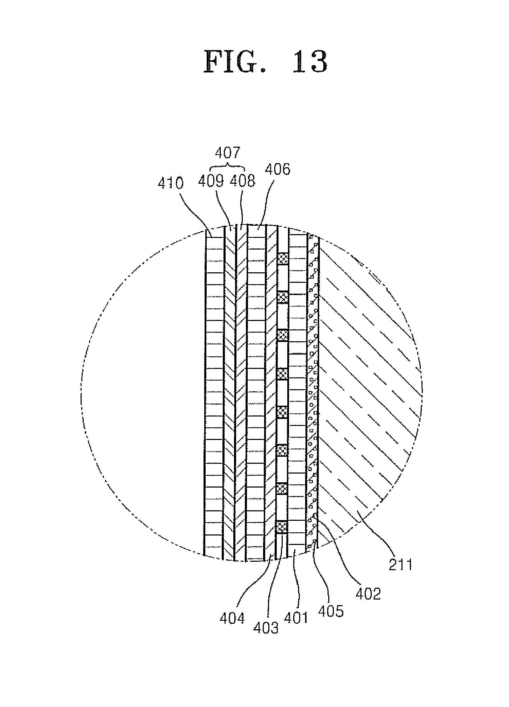

In some embodiments, referring to FIG. 13, the absorption coloring material 405 is mixed in the first adhesive layer 402 or both the first adhesive layer 402 and the second adhesive layer 404, but the present invention is not limited thereto.

The filter assembly 400 may further include a near infrared shield layer or a transmission adjustment layer. The near infrared shield layer is used to shield unnecessary luminescence of near infrared rays generated by plasma of an inert gas that is used for emission to display an image. The transmission adjustment layer is used to adjust an amount of transmitted light. In addition, the filter assembly 400 may include the above functions to an adhesive layer (e.g., adhesive layers 402 and 404) or further form a film having various functions.

The filter assembly 400 maintains a light transmittance between 20 and 90 % with regard to visible light that transmits through the first substrate 211 by exciting the phosphor layer according to ultraviolet rays generated by a discharge of the panel assembly 210. A haze value of the filter assembly 400 may be between 1 and 15 % in view of characteristics of a light. If the haze value exceeds 15 %, a display device emits a hazy light.

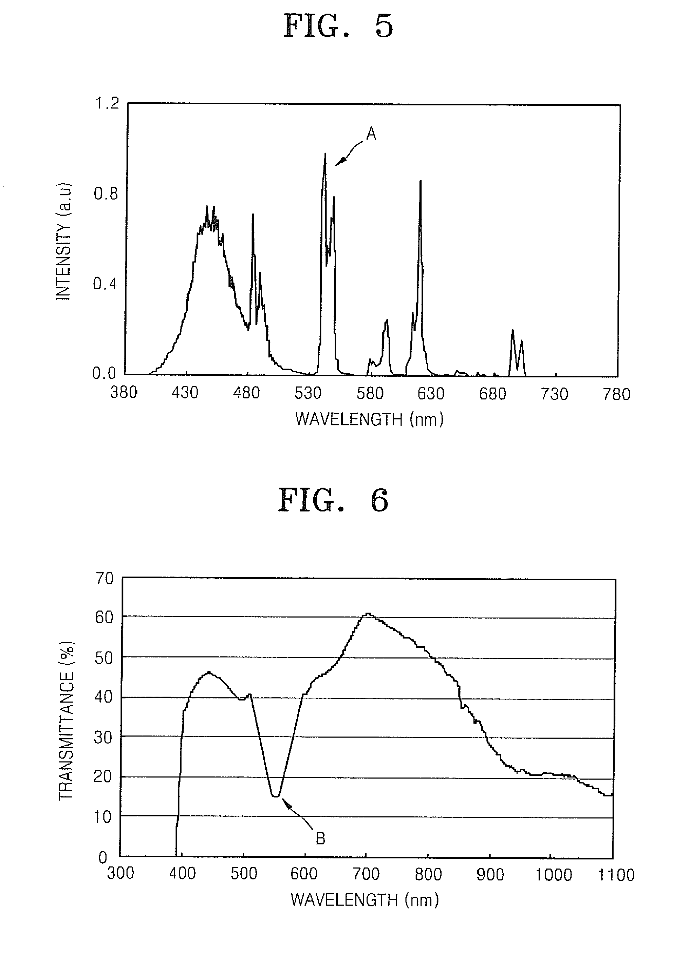

FIG. 5 is a graph illustrating a spectrum of a phosphor layer according to an embodiment of the present invention.

The phosphor layer includes the red phosphor layer formed of, preferably consists of Y(P,V)O₄;Eu, the green phosphor layer formed of, preferably consists of YAl₃(BO₃)Tb, and the blue phosphor layer formed of, preferably consists of BaMgAl₁₀O₁₇:Eu.

Referring to FIG. 5, the spectrum of the phosphor layer reaches a peak in a region A of a green wavelength between 550 and 560 nanometers and has a high transmittance greater than 80 %. The transmittance reduces a color purity of the region A at the green wavelength and lowers a color re-expression.

FIG. 6 is a graph illustrating a spectrum of the filter assembly 400 including the absorption coloring material 405 according to an embodiment of the present invention.

Referring to FIG. 6, the filter assembly 400 has a transmittance between 0.01 and 40 % in a region B of a green wavelength between 550 and 580 nanometers, preferably in the entire range between 550 and 580 nm. Thus, a color coordination moves from green or yellow color to green color in the region B of the green wavelength, thereby increasing a color re-expression of the filter assembly 400.

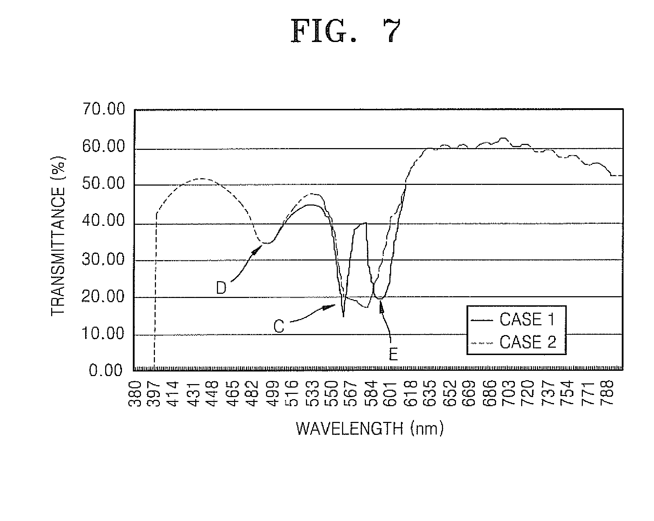

FIG. 7 is a graph illustrating a spectrum of the filter assembly 400 according to another embodiment of the present invention. In particular, the graphs "Case 1" and "Case 2" refer to different filter assembly specimens according to the present invention. Referring to FIG. 7, the filter assembly 400 has a transmittance between 0.01 and 40 % in a region C of a green wavelength between 550 and 580 nanometers preferably in the entire range between 550 and 580 nm, a transmittance between 0.01 and 40 % in a region D of a blue wavelength between 490 and 500 nanometers, preferably in the entire range between 490 and 500 nm. Also, the filter assembly 400 has a transmittance between 0.01 and 40 % in a region E of a neon wavelength between 590 and 600 nanometers preferably in the entire range between 590 and 600 nm, thereby increasing a color re-expression of the filter assembly 400.

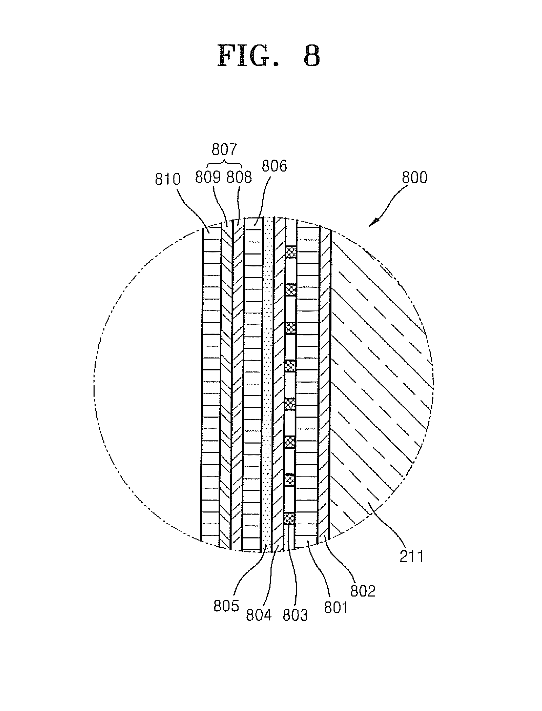

FIG. 8 is a partial cross-sectional view of a filter assembly 800 according to another embodiment of the present invention.

Referring to FIG. 8, the filter assembly 800 includes a first base film 801 and a second base film 806. The first and second base films 801 and 806 are formed of, preferably consists of the same material, for example, a high polymer resin selected from the group consisting of Polyethersulfone (PES), Polyacrylate (PAC), Polyetherimide (PEI), Polyethylene Naphthalate (PEN), Polyethylene Terephthalate (PET), Polyphenylene Sulfide (PPS), Polyimide (PI), Polycarbonate (PC), Cellulous Triacetate (CT), Cellulose Acetate Propionate (CAP), and combinations thereof.

A first adhesive layer 802 that is formed of, preferably consists of, for example, a polymer adhesive and a rubber adhesive material is disposed between, preferably directly between a surface of the first base film 801 and the first substrate 211, so that the filter assembly 800 is adhered to, preferably directly to the first substrate 211.

An electromagnetic wave shield filter 803 is adhered to, preferably directly to another surface of the first base film 801. The electromagnetic wave shield filter 803 may be formed by patterning a fine metal mesh or oxidizing and stacking conductive metal layers.

A second adhesive layer 804 that is formed of, preferably consists of, for example, a polymer adhesive and a rubber adhesive material is coated on, preferably directly on the electromagnetic wave shield filter 803. In the present embodiment, an absorption coloring material is not mixed in the second adhesive layer 804, but an absorption coloring layer 805 is formed on, preferably directly on the surface of the second adhesive layer 804. The absorption coloring layer 805 may include a compound having a maximum absorption rate at a wavelength between 550 and 580 nanometers. The absorption coloring layer 805 may be formed of, preferably consists of a compound of a cyanine derivative dye and an acryl derivative binder or a compound of a squarylium derivative dye and the acryl derivative binder.

The absorption coloring layer 805 has a maximum absorption rate at each wavelength of a blue region corresponding to a wavelength between 490 and 500 nanometers and a neon region corresponding to a wavelength between 590 and 600 nanometers in order to absorb each luminescent spectrum.

One surface of the second base film 806 is adhered to, preferably directly to the surface of the second absorption coloring layer 805. A reflection preventive layer 807 is formed on, preferably directly on another surface of the second base film 806. The reflection preventive layer 807 may be formed by stacking an AR film layer 808 and an AG film layer 809 or may include any one of layers 808 and 809. A third base film 810 is adhered to the surface of the reflection preventive layer 807.

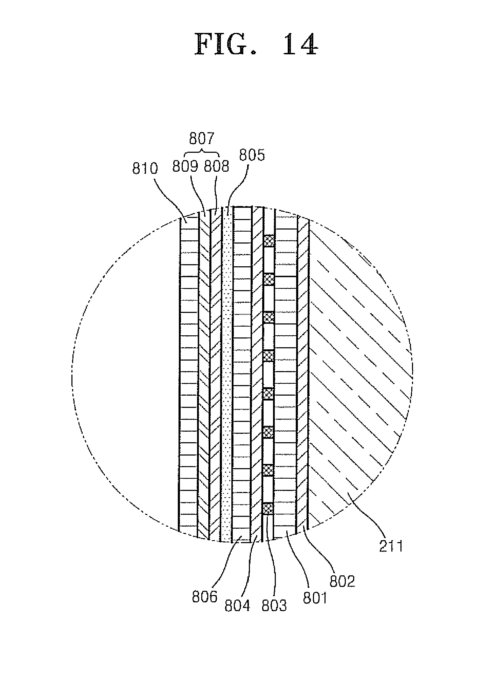

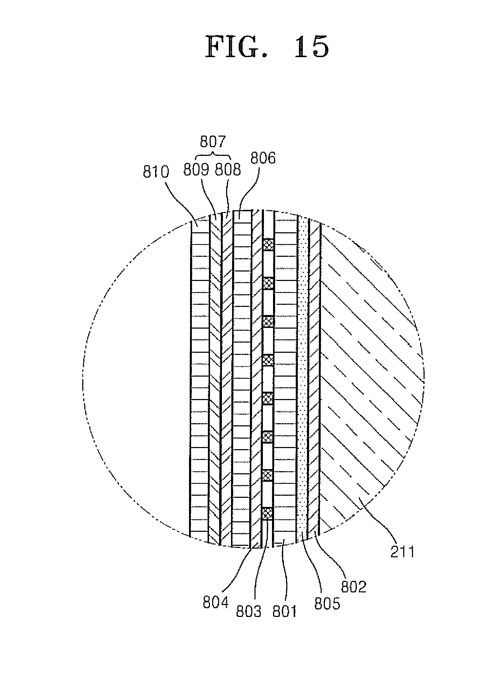

The absorption coloring layer 805 may be disposed between, preferably directly between the second base film 806 and the reflection preventive layer 807 as shown in FIG. 14 or, may be disposed between, preferably directly between the first base film 801 and the first adhesive layer 802 as shown in FIG. 15, but the present invention is not limited thereto.

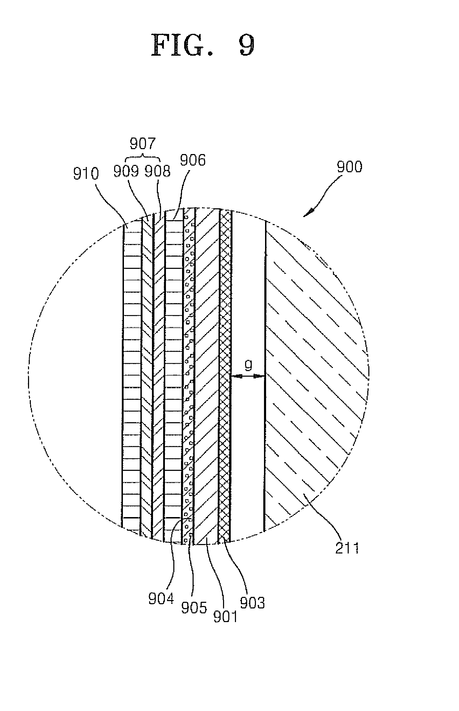

FIG. 9 is a partial cross-sectional view of a filter assembly 900 according to another embodiment of the present invention.

Referring to FIG. 9, the filter assembly 900 includes a base glass 901. The base glass 901 is a thick film type glass unlike a thin film type base film shown in FIGs. 4 and 8. Preferably, a thickness of the thin film base film is 100-600 µm and a thickness of the thick film type glass is 1.8 - 2.5 mm.

An electromagnetic wave shield filter 903 is adhered to one surface of the base glass 901, i.e., the surface of the base glass 901 facing the first substrate 211. The electromagnetic wave shield filter 903 is formed, for example, by patterning a fine metal mesh or oxidizing and stacking a transparent conductive film such as an ITO film and a conductive metal layer such as copper layers on the transparent conductive film, but the present invention is not limited thereto.

The electromagnetic wave shield filter 903 is spaced apart from the first substrate 211 so that a gap g is formed between the filter assembly 900 and the first substrate 211.

An adhesive layer 904 is coated on another surface of the base glass 901. The adhesive layer 904 is formed of, preferably consists of, for example, a polymer adhesive such as a PSA adhesive layer or a rubber adhesive material, but the present invention is not limited thereto.

An absorption coloring material 905 is mixed in the adhesive layer 904. The absorption coloring material 905 may include, preferably may consist of a compound having a maximum absorption ratio at a wavelength between 550 and 580 nanometers. The absorption coloring material 905 may be formed of, preferably consists of a compound of a cyanine derivative dye and an acryl derivative binder or a compound of a squarylium derivative dye and the acryl derivative binder.

The filter assembly 900 including the absorption coloring material 905 has a minimum transmittance at a wavelength between 550 and 580 nanometers that includes a luminescent spectrum of a green region.

The absorption coloring material 905 has a maximum absorption rate at a wavelength of a blue region corresponding to a wavelength between 490 and 500 nanometers, at a wavelength of a neon region corresponding to a wavelength between 590 and 600 nanometers, or at the wavelengths of the blue region corresponding to the wavelength between 490 and 500 nanometers and the neon region corresponding to the wavelength between 590 and 600 nanometers.

One surface of a first base film 906 is adhered to, preferably directly to the surface of the adhesive layer 904 in which the absorption coloring material 905 is mixed. The second base film 906 is formed of, preferably consists of, for example, a high polymer resin selected from the group consisting of Polyethersulfone (PES), Polyacrylate (PAC), Polyetherimide (PEI), Polyethylene Naphthalate (PEN), Polyethylene Terephthalate (PET), Polyphenylene Sulfide (PPS), Polyimide (PI), Polycarbonate (PC), Cellulous Triacetate (CT), Cellulose Acetate Propionate (CAP), and combinations thereof.

A reflection preventive layer 907 is formed on, preferably directly on another surface of the first base film 906. The reflection preventive layer 907 is formed, for example, by stacking an AR film layer 908 and an AG film layer 909 together or any one of them. A second base film 910 is formed on, preferably directly on the surface of the reflection preventive layer 907.

The filter assembly 900 may further include a near infrared shield layer or a transmission adjustment layer. In addition, the filter assembly 900 may include a filter function in an adhesive layer or further form a film having various functions.

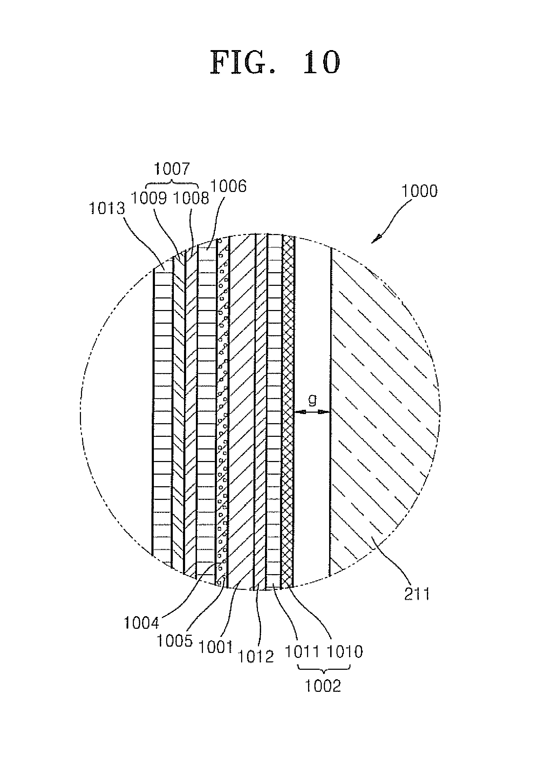

FIG. 10 is a partial cross-sectional view of a filter assembly 1000 according to another embodiment of the present invention.

Referring to FIG. 10, the filter assembly 1000 includes a base glass 1001. An electromagnetic wave shield filter 1002 is adhered to, preferably directly to one surface of the base glass 1001, i.e., the surface of the base glass 1001 facing the first substrate 211. The electromagnetic wave shield filter 1002 is spaced apart from the first substrate 211 so that a gap g is formed between the filter assembly 1000 and the first substrate 211.

A first adhesive layer 1004 is formed on, preferably directly on another surface of the base glass 1001. The first adhesive layer 1004 is formed of, preferably consists of, for example, a polymer adhesive or a rubber adhesive material.

An absorption coloring material 1005 is mixed in the first adhesive layer 1004. The absorption coloring material 1005 may include a compound having a maximum absorption ratio at a wavelength between 550 and 580 nanometers.

One surface of a first base film 1006 is adhered to, preferably directly to the surface of the first adhesive layer 1004 in which the absorption coloring material 1005 is mixed. A reflection preventive layer 1007 is formed on, preferably directly on another surface of the first base film 1006. A third base film 1013 is formed on, preferably directly on a surface of the reflection preventive layer 1007.

The electromagnetic wave shield filter 1002 includes a second base film 1011, unlike the previous embodiment shown in FIG. 9, and an electromagnetic wave shield layer 1010 that is formed on, preferably directly on one surface of the second base film 1011, i.e., the surface of the second base film 1011 facing the first substrate 211. The electromagnetic wave shield layer 1011 may be formed, for example, by patterning a fine metal mesh or oxidizing and stacking a transparent conductive film and a conductive metal layer.

A second adhesive layer 1012 is disposed between, preferably directly between the base glass 1001 and the electromagnetic wave shield filter 1002 so that the electromagnetic wave shield filter 1002 is adhered to the base glass 1001.

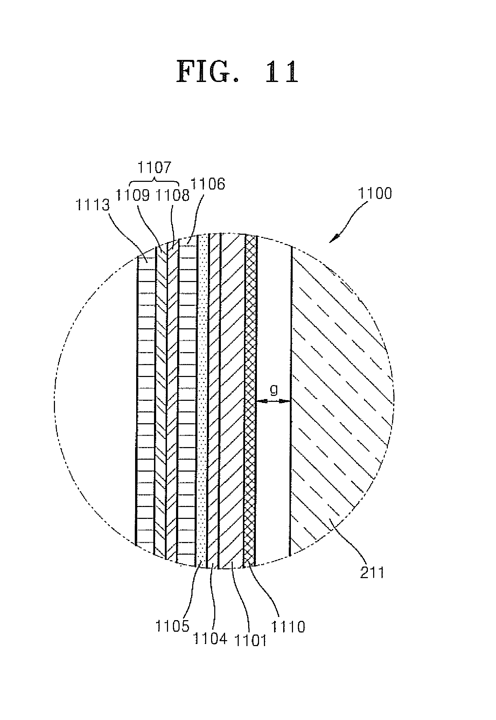

FIG. 11 is a partial cross-sectional view of a filter assembly 1100 according to another embodiment of the present invention.

Referring to FIG. 11, the filter assembly 1100 includes a base glass 1101. An electromagnetic wave shield filter 1110 is formed on, preferably directly on one surface of the base glass 1101, i.e., the surface of the base glass 1101 facing the first substrate 211. The electromagnetic wave shield filter 1110 is spaced apart from the first substrate 211 so that a gap g is formed between the filter assembly 1100 and the first substrate 211.

An adhesive layer 1104 is formed on, preferably directly on another surface of the base glass 1101. The adhesive layer 1104 is formed of, preferably consists of, for example, a polymer adhesive or a rubber adhesive material. Unlike the previous embodiments shown in FIGs. 9 and 10, an absorption coloring material 1105 is formed on, preferably directly on the surface of the adhesive layer 1104.

The absorption coloring layer 1105 may include a compound having a maximum absorption ratio at a wavelength between 550 and 580 nanometers. The absorption coloring layer 1105 may be formed of, preferably consists of a compound of a cyanine derivative dye and an acryl derivative binder or a compound of a squarylium derivative dye and the acryl derivative binder.

The absorption coloring layer 1105 additionally has a maximum absorption rate at a wavelength of a blue region corresponding to a wavelength between 490 and 500 nanometers, at a wavelength of a neon region corresponding to a wavelength between 590 and 600 nanometers, or at the wavelengths of the blue region corresponding to the wavelength between 490 and 500 nanometers and the neon region corresponding to the wavelength between 590 and 600 nanometers so as to absorb a luminescent spectrum.

A first base film 1106 is adhered to, preferably directly to a surface of the absorption coloring layer 1105. A reflection preventive layer 1107 is formed on, preferably directly on another surface of the first base film 1106. The reflection preventive layer 1107 is formed, for example, by stacking an AR film layer 1108 and an AG film layer 1109. A second base film 1113 is formed on, preferably directly on the surface of the reflection preventive layer 1107.

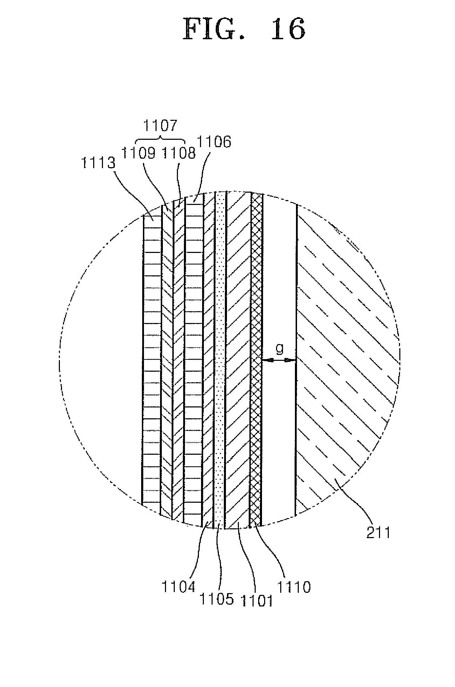

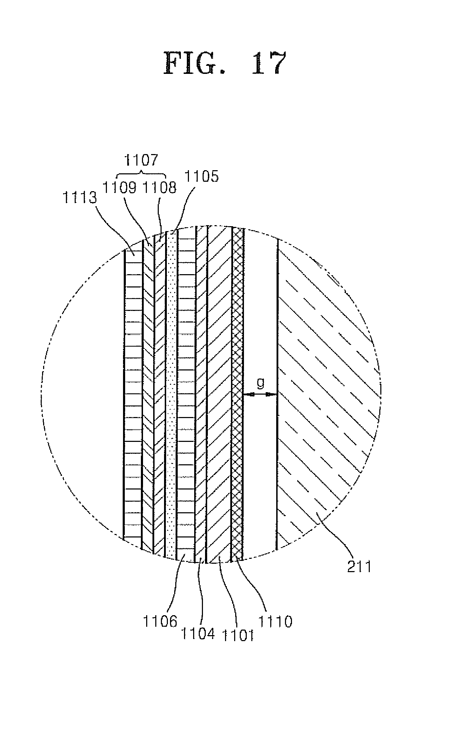

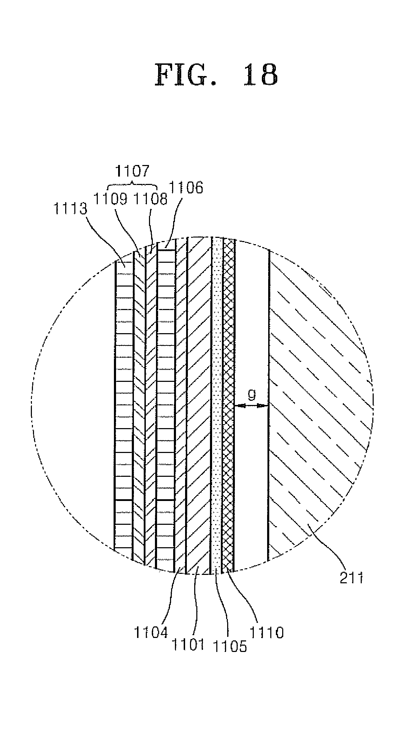

In some embodiments, the absorption coloring material 1105 may be disposed between, preferably directly between the base glass 1101 and the adhesive layer 1104 as shown in FIG. 16, may be disposed between, preferably directly between the first base film 1106 and the reflection preventive layer 1107 as shown in FIG. 17, or may be disposed between, preferably directly between the base glass 1101 and the electromagnetic wave shield filter 1110 as shown in FIG. 18, but the present invention is not limited thereto.

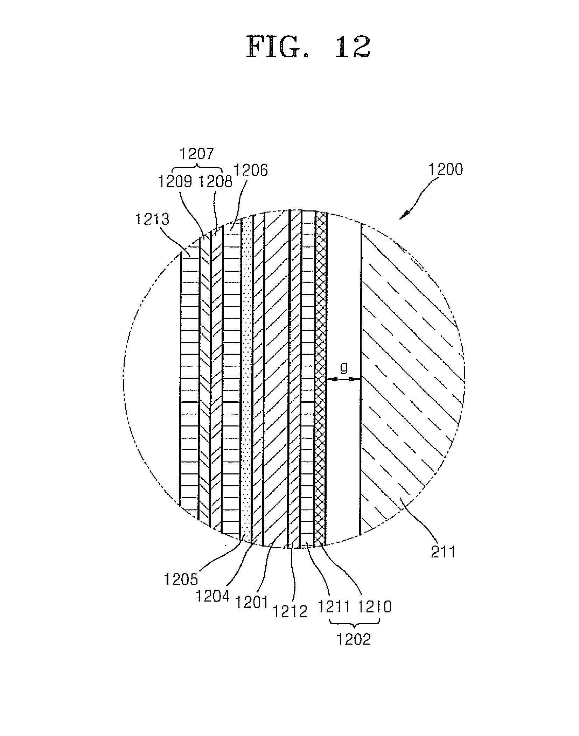

FIG. 12 is a partial cross-sectional view of a filter assembly 1200 according to another embodiment of the present invention.

Referring to FIG. 12, the filter assembly 1200 includes a base glass 1201. An electromagnetic wave shield filter 1202 is formed on, preferably directly on one surface of the base glass 1201, i.e., the surface of the base glass 1201 facing the first substrate 211. The electromagnetic wave shield filter 1202 is spaced apart from the first substrate 211 so that a gap g is formed between the filter assembly 1200 and the first substrate 211.

A first adhesive layer 1204 is formed on, preferably directly on another surface of the base glass 1201. The first adhesive layer 1204 is formed of, preferably consists of, for example, a polymer adhesive or a rubber adhesive material. An absorption coloring layer 1205 is formed on, preferably directly on a surface of the first adhesive layer 1204.

The absorption coloring layer 1205 may include a compound having a maximum absorption ratio at a wavelength between 550 and 580 nanometers. The absorption coloring layer 1205 may be formed of, preferably consists of a compound of a cyanine derivative dye and an acryl derivative binder or a compound of a squarylium derivative dye and the acryl derivative binder.

One surface of a first base film 1206 is adhered to, preferably directly to a surface of the absorption coloring layer 1205. A reflection preventive layer 1207 is formed on, preferably directly on another surface of the first base film 1206. The reflection preventive layer 1207 is formed, for example, by stacking an AR film layer 1208 and an AG film layer 1209. A third base film 1213 is adhered to, preferably directly to a surface of the reflection preventive layer 1207.

The electromagnetic wave shield filter 1202 includes a second base film 1211, unlike the previous embodiment shown in FIG. 11. An electromagnetic wave shield layer 1210 is formed on, preferably directly on one surface of the second base film 1211, i.e., the surface of the second base film 1211 facing the first substrate 211. A second adhesive layer 1212 is disposed between, preferably directly between the base glass 1201 and the electromagnetic wave shield filter 1202 so that the electromagnetic wave shield filter 1202 is adhered to, preferably directly to the base glass 1201.

The display panel according to the above embodiments of the present invention provides the following effects.

First, the display panel has a minimum transmittance at a wavelength including a region of a green wavelength so that light having undesirable wavelength is absorbed, and a color reproduction of the display panel is increased.

Second, the display panel has a minimum transmittance at a wavelength of a region of a blue wavelength or a region of a neon wavelength, and a color purity of the display panel is increased.

Third, an absorption coloring material is mixed in an adhesive layer, or an absorption coloring layer is coated on, preferably directly on the surface of the adhesive layer, so that undesirable wavelengths of the phosphor spectrum can be reduced, and the manufacturing of the display panel becomes less complicated.

While the present invention has been particularly shown and described with reference to exemplary embodiments thereof, it will be understood by those of ordinary skill in the art that various changes in form and details may be made therein without departing from the scope of the invention as defined by the appended claims and their equivalents. The exemplary embodiments should be considered in a descriptive sense only and not for purposes of limitation. Therefore, the scope of the present invention is defined not by the detailed description of the embodiments of the present invention but by the appended claims and their equivalents, and all differences within the scope will be construed as being included in the present invention.

## Claims

1. A display panel (200) comprising:
a panel assembly (201) having a plurality of substrates (211, 212), the panel assembly (201) for displaying an image by utilizing luminescence of a phosphor layer (325) in the panel assembly (201); and
a filter assembly (220) coupled to the panel assembly (201) and having a minimum transmittance at a wavelength between 550 and 580 nanometers.

2. The display panel (200) of claim 1, wherein the filter assembly comprises:
a base film;
an adhesive layer on the base film; and
an absorption coloring material (405) included in the adhesive layer,
wherein the absorption coloring material (405) comprises a compound having a maximum absorption rate at the wavelength between 550 and 580 nanometers.

3. The display panel (200) of claim 2, wherein the base film comprises a first base film (401) and a second base film (406),
wherein the adhesive layer comprises a first adhesive layer (402) and a second adhesive layer (404),
wherein the first adhesive layer (402) is arranged between a first side of the first base film (401) and the panel assembly (201),
wherein an electromagnetic wave shield filter (403) is arranged on another, a second side of the first base film (401),
wherein the second adhesive layer (404) is arranged on the electromagnetic wave shield filter (403),
wherein the second base film (406) is arranged on a side of the second adhesive layer (404), and
wherein a reflection preventive layer (407) is arranged on a side of the second base film (406),
wherein the first adhesive layer (402) comprises the absorption coloring material (405) or the second adhesive layer (404) comprises the absorption coloring material (405).

4. The display panel (200) of claim 1, wherein the filter assembly comprises:
a base film; and
an absorption coloring layer (805) coated on a side of the base film and comprising a compound having a maximum absorption rate at the wavelength between 550 and 580 nanometers.

5. The display panel (200) of claim 4, wherein the base film comprises a first base film (801) and a second base film (806),
wherein a first adhesive layer (802) is between a first side of the first base film (801) and the panel assembly (201),
wherein an electromagnetic wave shield filter (803) is on a second side of the first base film (801),
wherein a second adhesive layer (804) is on a side of the electromagnetic wave shield filter (803),
wherein the absorption coloring layer (805) is on a side of the second adhesive layer (804),
wherein the second base film (806)is on a side of the absorption coloring layer (805), and
wherein a reflection preventive layer (807) is on a side of the second base film (806).

6. The display panel (200) of claim 4, wherein the base film comprises a first base film (801) and a second base film (806),
wherein a first adhesive layer (802) is between a first side of the first base film (801) and the panel assembly (201),
wherein an electromagnetic wave shield filter (803) is on a second side of the first base film (801),
wherein a second adhesive layer (804) is on a side of the electromagnetic wave shield filter (803),
wherein the second base film (806) is on a side of the second adhesive layer (804),
wherein the absorption coloring layer (805) is on a side of the second base film (806), and
wherein a reflection preventive layer (807) is on a side of the absorption coloring layer (805).

7. The display panel (200) of claim 4, wherein the base film comprises a first base film (801) and a second base film (806),
wherein an absorption coloring layer (805) and a first adhesive layer (802) are between a first side of the first base film (801) and the panel assembly (201),
wherein an electromagnetic wave shield filter (803) is on a second side of the first base film (801),
wherein a second adhesive layer (804) is on a side of the electromagnetic wave shield filter (801),
wherein the second base film (806) is on a side of the second adhesive layer (804), and
wherein a reflection preventive layer (807) is on a side of the second base film (806).

8. The display panel (200) of claim 1, wherein the filter assembly comprises:
a base glass (901);
an adhesive layer (904) on a surface of the base glass (901); and
an absorption coloring material (905) included in the adhesive layer (904),
wherein the absorption coloring material (905) comprises a compound having a maximum absorption rate at the wavelength between 550 and 580 nanometers.

9. The display panel (200) of claim 8, wherein an electromagnetic wave shield filter (903) is on a first side of the base glass (901) facing the panel assembly (201),
wherein the adhesive layer (904) is on a second side of the base glass (901) and comprises the absorption coloring material (905),
wherein a first base film (906) is on a side of the adhesive layer (904), and
wherein a reflection preventive layer (907) is on a side of the first base film (906).

10. The display panel (200) of claim 9, wherein the electromagnetic wave shield filter (1002) comprises;
a second based film (1011);
an electromagnetic wave shield layer (1010) on a first side of the second base film
(1011) facing the panel assembly (201); and
a second adhesive layer (1004) on a second side of the second based film (1004),
wherein the second adhesive layer (1004) is between the base glass (1001) and the second base film (1011).

11. The display panel (200) of claim 1, wherein the filter assembly comprises:
a base glass (1101); and
an absorption coloring layer (1105) on the base glass (1101), wherein the absorption coloring layer (1105) comprises a compound having a maximum absorption rate at the wavelength between 550 and 580 nanometers.

12. The display panel (200) of claim 11, wherein an electromagnetic wave shield filter (1110) is on a first side of the base glass (1101) facing the panel assembly (201),
wherein an adhesive layer (1104) is on a second side of the base glass (1101),
wherein the absorption coloring layer (11015 is on a side of the adhesive layer (1104),
wherein a first base film (1106) is on a side of the absorption coloring layer (1105),
and
wherein a reflection preventive layer (1107) is on a side of the first base film (1106).

13. The display panel (200) of claim 12, wherein the electromagnetic wave shield filter (1202) comprises:
a second base film (1211);
an electromagnetic wave shield layer (1210) on a first side of the second base film (1211) facing the panel assembly (201); and
a second adhesive layer (1212) on a second side of the second based film (1211),
wherein the second adhesive layer (1212) is between the base glass (1201) and the second base film (1211).

14. The display panel (200) of claim 11, wherein an electromagnetic wave shield filter (1110) is on a first side of the base glass (1101) facing the panel assembly (201),
wherein the absorption coloring layer (1105) is on a second side of the base glass (1101),
wherein an adhesive layer (1104) is on a side of the absorption coloring layer (1105),
wherein a first base film (1106) is on a side of the adhesive layer (1104), and
wherein a reflection preventive layer (1107) is on a side of the first base film (1106).

15. The display panel (200) of claim 11, wherein an electromagnetic wave shield filter (1110) is on a first side of the base glass (1101) facing the panel assembly (201),
wherein an adhesive layer (1104) is on a second side of the base glass (1101),
wherein a first base film (1106) is on a side of the adhesive layer (1104),
wherein the absorption coloring layer (1105) is on a side of the first base film (1106), and
wherein a reflection preventive layer (1107) is on a side of the absorption coloring layer (1105).

16. The display panel (200) of claim 11, wherein the absorption coloring layer (1105) is on a first surface of the base glass (1101) facing the panel assembly (201),
wherein an electromagnetic wave shield filter (1110) is on a side of the absorption coloring layer (1105),
wherein an adhesive layer (1104) is on a second side of the base glass (1101),
wherein a first base film (1106) is on a side of the adhesive layer (1104), and
wherein a reflection preventive layer (1107) is on a side of the first base film (1106).

17. The display panel (200) of any of the previous claims, wherein the adhesive layer or wherein the first adhesive layers and the second adhesive layer comprise a polymer adhesive or a rubber material.

18. The display panel (200) of any of the previous claims, wherein the absorption coloring layer or absorption coloring material comprises:
a cyanine derivative dye and an acryl derivative binder, or a squarylium derivative dye and an acryl derivative binder.

19. The display panel (200) of claims 2 or 4, wherein the filter assembly is adhered to a front surface of the panel assembly.

20. The display panel (200) of claims 8 or 11, wherein the filter assembly is spaced apart from the panel assembly by a gap.

21. The display panel (200) of any of the previous claims, wherein the minimum transmittance of the filter assembly comprises a transmittance between 0.01 and 40 % at the wavelength between 550 and 580 nanometers.

22. The display panel (200) of any of the previous claims, wherein the minimum transmittance of the filter assembly further comprises a first minimum transmittance at a wavelength between 490 and 500 nanometers and a second minimum transmittance at a wavelength between 590 and 600 nanometers and/or has a transmittance between 0.01 and 40 % at the wavelength between 490 and 500 nanometers and at the wavelength between 590 and 600 nanometers.

23. The display panel (200) of any of the previous claims, wherein the filter assembly has a visible light transmittance between 20 and 90 %.

24. The display panel (200) of any of the previous claims, wherein the phosphor layer comprises a red phosphor layer formed of, preferably consists of Y(P,V)O₄;Eu, a green phosphor layer formed of, preferably consists of YAl₃(BO₃)Tb, and a blue phosphor layer formed of, preferably consists of BaMgAl₁₀O₁₇:Eu.
